# EUROPEAN PATENT APPLICATION

(11) **EP 4 722 103 A1**
(43) Date of publication of application: **08.04.2026**
(21) Application number: 25206331.8
(22) Date of filing: 02.10.2025
(51) Int. Cl.: B64D 27/33, B64D 31/18, B64F 5/60

(54) **INSPECTION DEVICE FOR CHECKING PERFORMANCE OF POWERTRAIN FOR MOBILITY APPARATUS AND INSPECTION METHOD USING THE SAME**

(30) Priority: 07.10.2024 KR 20240135476
(71) Applicant: Hyundai Motor Company, Seoul 06797 (KR); Kia Corporation, Seoul 06797 (KR)
(72) Inventor: JUNG, Woo Suk, 18280 Hwaseong-si (KR); JANG, Mun Jeong, 18280 Hwaseong-si (KR); KIM, Jong Pil, 18280 Hwaseong-si (KR); HONG, Hyun Seok, 18280 Hwaseong-si (KR)
(74) Representative: Viering, Jentschura & Partner mbB Patent- und Rechtsanwälte

(57) **Abstract**

An inspection device includes a switching assembly including a switch array configured to allow or block power flow to at least one component among a plurality of components of an aircraft having a heterogeneous power source module and a propulsor driven by the power source module; and one or more processors configured to control the switch array to allow or block power flow to the at least one component based on an inspection mode related to at least one of the power source module and the propulsor and output diagnostic data for the at least one component by performing an inspection according to the inspection mode.

## Description

### CROSS-REFERENCE TO RELATED APPLICATION

This application claims priority to and the benefit of Korean Patent Application No. 10-2024-0135476 filed on October 7, 2024, the disclosure of which is incorporated herein by reference in its entirety.

### TECHNICAL FIELD

The present disclosure relates to an inspection device for checking the performance of a powertrain and an inspection method using the same. More specifically, the present disclosure relates to an inspection device and method that can easily and simply inspect the performance of a powertrain for a mobility apparatus at a site without actual flight by providing a flexible powertrain architecture according to an operation environment that requires an inspection of an electrified powertrain of the mobility apparatus having a heterogeneous power source and an electric propulsor.

### BACKGROUND

With the development of technology, various transport mobility devices are emerging. Advanced air mobility (AAM) devices are actively being developed to reduce ground traffic congestion and urban environmental degradation. An AAM device can move to a specific point in a complex city center and provide services associated with other types of mobility devices, such as ground mobility devices.

### SUMMARY

Aspects of the present disclosure provide an inspection device and method for simply and easily checking the performance of a powertrain for a mobility apparatus without actual flight, for example, by providing a flexible powertrain architecture according to an operating environment that may require inspection in an electric powertrain of an aircraft having a heterogeneous power source and an electric propulsor.

In some implementations,, there is provided an inspection device for checking performance of a powertrain for a mobility apparatus. The inspection device comprises: a switching assembly including a switch array configured to allow or block power flow to at least one component among a plurality of components of an aircraft having a heterogeneous power source module and a propulsor driven by the power source module; and one or more processors configured to: control the switch array to allow or block the power flow to the at least one component based on an inspection mode related to at least one of the power source module or the propulsor; and output diagnostic data for the at least one component by performing an inspection according to the inspection mode.

In some implementations, the heterogeneous power source module includes a rechargeable battery and at least one power source that allows self-power generation, and at least one of the rechargeable battery or the at least one power source is configured to supply power to the propulsor, and wherein, based on the inspection mode being a failure mode indicating a defect of at least one of the heterogeneous power source module or the propulsor, the one or more processors are configured to control the switch array to: block power flow to a first component among the plurality of components, wherein the first component is identified as failed; and allow power flow to a second component among the plurality of components, wherein the second component is identified as normal.

In some implementations, the heterogeneous power source module includes a rechargeable battery and at least one power source that allows self-power generation, and the power source is configured to charge the rechargeable battery, wherein the switch array is disposed along a plurality of transmission lanes and has a same arrangement in each of the plurality of transmission lanes, and wherein, based on the inspection mode being an on-board charging mode in which the battery is charged, the one or more processors are configured to control the switch array on a first transmission lane and a second transmission lane among the plurality of transmission lanes to: allow power flow, on the first transmission lane, to a third component including the propulsor and a power source configured to supply power to the propulsor, and allow power flow, on at least one of the first transmission lane or the second transmission lane, to a fourth component including the rechargeable battery and the power source configured to charge the rechargeable battery.

In some implementations, the inspection device comprises a power transceiver configured to provide power to the propulsor or function as a load of the aircraft according to the inspection mode, wherein the switching assembly includes a switch array operated to allow or block power flow to the power transceiver inside the switching assembly.

In some implementations, the heterogeneous power source module comprises a plurality of heterogeneous power source modules, wherein, based on the inspection mode being a simultaneous power mode in which power is supplied to the propulsor and the load by at least one heterogeneous power source module of the plurality of heterogeneous power source modules, the one or more processors are configured to control the switch array to allow power flow to components including the at least one heterogeneous power source module, the propulsor, and the power transceiver.

In some implementations, the power transceiver is configured to receive power required for the load, and the load includes at least one of avionics equipment, a non-propulsion system actuator, and an icing prevention/removal device.

In some implementations, based on the inspection mode being a source hybrid mode in which power is supplied to the load by performing power control based on combination power of the at least one heterogeneous power source module, the one or more processors are configured to control the switch array to allow power flow to only a component including the power source module and the power transceiver, thereby applying power of the at least one heterogeneous power source module to the power transceiver.

In some implementations, the diagnostic data is data representing at least one of redundancy performance due to an abnormal situation of the power source module and the propulsor, performance of the power source module, on-board charging performance between the power source modules, or performance of the propulsor, wherein the redundancy performance is performance related to redundancy of the propulsor, power distribution of the power source module, and power block of the power source module in the abnormal situation, wherein the performance of the power source module is performance related to at least one of output power, power generation, charging, and operation control of a power source constituting the power source module, wherein the on-board charging performance is performance related to charging control and operation control between power sources constituting the power source module according to a power operating mode of the aircraft, and wherein the performance of the propulsor is performance related to output power of the propulsor and control of the propulsor according to a flight mode of the aircraft.

In some implementations, the switch array is disposed along a plurality of transmission lanes, and wherein the plurality of transmission lanes are configured to divide and supply power, or wherein a first transmission lane among the plurality of transmission lanes is configured to function as a main transmission lane, and at least one second transmission lane among the plurality of transmission lanes is configured to function as a redundancy transmission lane.

In some implementations, the heterogeneous power source module includes a rechargeable battery and at least one power source that allows self-power generation, the at least one power source includes at least one fuel cell and an internal combustion engine-based generator, and wherein the propulsor comprises a plurality of propulsors.

In some implementations, an inspection method of checking performance of a powertrain for a mobility apparatus by an inspection device including a switching assembly having a switch array configured to allow or block power flow to at least one component among a plurality of components of an aircraft having a heterogeneous power source module and a propulsor driven by the power source module is provided. The inspection method comprises: connecting the aircraft and the inspection device; controlling, by the switching assembly, the switch array to allow or block the power flow to the at least one component based on an inspection mode related to at least one of the power source module or the propulsor; and outputting diagnostic data for the at least one component by performing an inspection according to the inspection mode.

The features briefly summarized above for this disclosure are only exemplary aspects of the detailed description of the disclosure which follow, and are not intended to limit the scope of the disclosure.

### BRIEF DESCRIPTION OF THE DRAWINGS

FIG. 1 is a view illustrating a state in which an inspection device for checking the performance of an aircraft powertrain is connected to an aircraft for inspection according to an implementation of the present disclosure;
FIG. 2 is a view illustrating the aircraft according to the present disclosure;
FIG. 3 is a schematic view illustrating modules of the aircraft according to the present disclosure;
FIG. 4 is a view illustrating modules constituting the inspection device according to an implementation of the present disclosure and illustrating components of the aircraft, which are inspected by the inspection device;
FIG. 5 is a flowchart illustrating an inspection method for checking the performance of an aircraft powertrain according to an implementation of the present disclosure; and
FIGS. 6 to 14 are views illustrating components of an aircraft, which are diagnosed according to various inspection modes, and switching operations of the inspection device according to an inspection mode.

### DETAILED DESCRIPTION

Hereinafter , exemplary implementations of the present disclosure will be described in detail with reference to the accompanying drawings so that those skilled in the art can easily implement the present disclosure. However, the present disclosure can be implemented in various different ways, and is not limited to the implementations described therein.

In the present disclosure, elements that are distinguished from each other are for clearly describing each feature, and do not necessarily mean that the elements are separated. That is, a plurality of elements can be integrated in one hardware or software unit, or one element can be distributed and formed in a plurality of hardware or software units. Therefore, even if not mentioned otherwise, such integrated or distributed implementations are included in the scope of the present disclosure.

The advantages and features of the present disclosure and the way of attaining them will become apparent with reference to implementations described below in detail in conjunction with the accompanying drawings. Implementations, however, can be embodied in many different forms and should not be constructed as being limited to example implementations set forth herein. Rather, these implementations are provided so that this disclosure will be complete and will fully convey the scope of the present disclosure to those skilled in the art.

AAM devices may be designed to adopt an electrification propulsion system for reducing noise and improving an environment. Powertrains using only electric batteries as power sources may be mainly considered for AAM devices, but a weight of the electrified propulsion system can be increased due to limitation of energy density of batteries. To improve performance and safety of the system, an additional power source such as a fuel cell or an internal combustion engine-based generator can be applied in addition to the batteries.

When operating a powertrain that combines multiple power sources according to the specifications of AAM devices, it may be required to simulate realistic conditions within a virtual operating environment, which may enable performance and maintenance inspections prior to takeoff. Specifically, the architecture of the powertrain and the safety inspection methods required in failure scenarios become increasingly complex depending on the combination of power sources. As a result, establishing an appropriate environment for performance evaluation remains a persistent challenge.

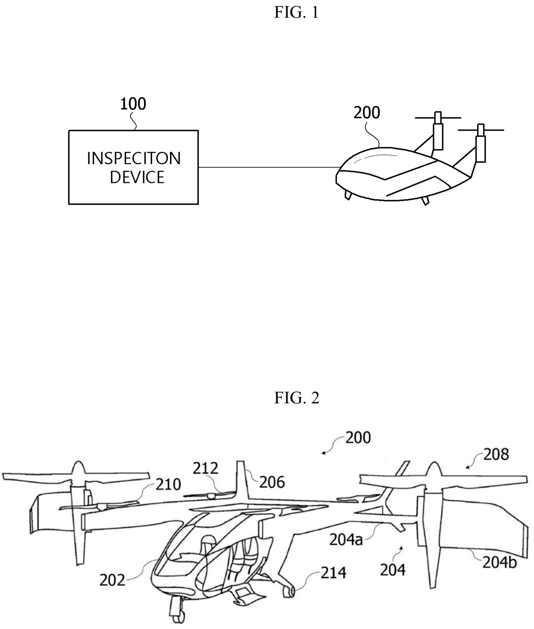

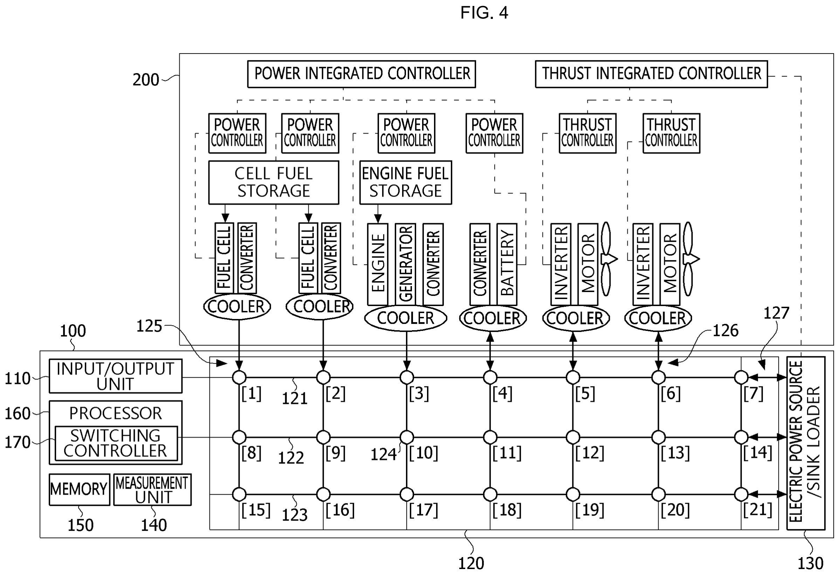

Aspects of the present disclosure may address the above-discussed issues in the related art. Hereinafter, implementations of the present disclosure will be described with reference to the accompanying drawings. Hereinafter, an inspection device for checking the performance of an aircraft powertrain according to an implementation of the present disclosure will be described with reference to FIGS. 1 and 4. FIG. 1 is a view illustrating a state in which the inspection device for checking the performance of an aircraft powertrain is connected to an aircraft for inspection according to an implementation of the present disclosure.

In this example, a mobility apparatus whose performance is checked by the inspection device is described as the aircraft. However, the aircraft can be used interchangeably with the mobility apparatus in the present disclosure and claims. Also, the inspection device according to the present disclosure can be utilized for other types of mobility devices (e.g., ground mobility device) besides an aircraft, as long as there is no technical contradiction.

The inspection device 100 can be a device that diagnoses the performance of a powertrain of an aircraft 200 that is propelled based on electrical energy. The aircraft 200 has a heterogeneous power source module and a propulsor driven by the power source module, and the power source module and the propulsor can constitute a powertrain of the aircraft. The inspection device 100 can provide diagnostic data of components related to an inspection mode by performing an inspection according to the inspection mode in order to check various performances of components in the aircraft 200 before takeoff or during maintenance. The inspection device 100 can be connected to the aircraft 200 parked in a predetermined space, such as a vertiport or a maintenance area, through a cable in which power and various signals are exchanged, so as to inspect the aircraft 200.

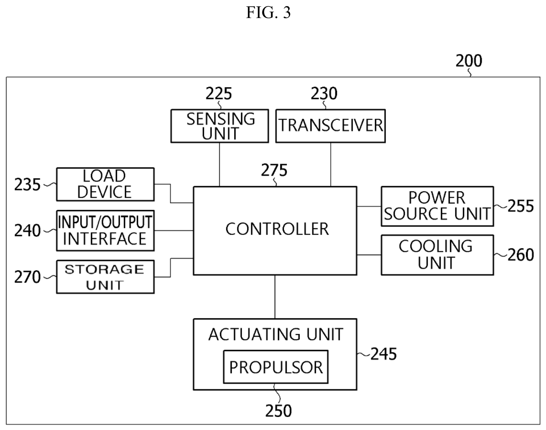

First, the aircraft 200 inspected by the inspection device 100 will be described with reference to FIGS. 2 and 3. FIG. 2 is a view illustrating the aircraft according to the present disclosure. FIG. 3 is a schematic view illustrating modules of the aircraft according to the present disclosure. In the present disclosure, an aircraft can also be referred to as an air mobility device.

In the present disclosure, the aircraft 200 can employ a vertical take-off and landing (VTOL) type of vectored thrust, that is, a tilting rotor, as a take-off and landing method and a propulsion method. However, the aircraft can be propelled by a lift and cruise method, a multicopter, or the like. Further, the aircraft can be manufactured in types such as short take-off and landing (STOL) or conventional take-off and landing (CTOL), depending on the take-off and landing method. The present disclosure is not limited thereto, and as long as the aircraft 200 is a flying object that is propelled based on electrical energy, the present implementation is applied to various types of aircrafts.

The aircraft 200 can include a streamlined fuselage 202, main wings 204 arranged on left and right sides of a central region of the fuselage 202, and a tail wing 206 disposed in an end of the fuselage 202. The fuselage 202 can have, for example, a cabin in which a pilot and a passenger are on board and a space for loading luggage. The main wings 204 and the tail wing 206 can be wings having a fixed shape.

The main wing 204 can have an inboard area and an outboard area. A tilting propulsor 208 having the tilting rotor can be disposed in a front area of left and right outboards. The tilting propulsor 208 can be fixed to the main wing 204 by a boom provided in the outboard area of the main wing 204. Non-tilting propulsors 210 and 212 arranged in a horizontal direction of the fuselage 202 can be arranged in front and rear areas of a rod extending from left and right inboard areas and can also be referred to as lift propulsors. Each of the propulsors described above can have a propeller having a plurality of blades, a hub to which an end of each of the blades is coupled and which has a shaft, a motor that supplies a rotational force to the shaft, an inverter, a propulsor cooling module, and the like. The inverter can adjust power of a power source unit 255 or convert a power form based on a flight situation, a motor specification, and the like. The propulsor cooling module can cool the motor and the inverter. In the present disclosure, the propulsor can be referred to as a rotor, a propulsion assembly, or the like.

Meanwhile, the outboard area of the main wing 204 can include a lift surface 204b distinguished from a horizontal surface 204a of the inboard area, and the tilting propulsor 208 can be mounted on the boom protruding from the lift surface 204b. As an example, the tilting propulsor 208 and the lift surface 204b can be configured to rotate or move together. As another example different from that of FIG. 2, the tilting propulsor 208 can be coupled to the boom disposed at the end of the main wing 204, and the tilting propulsor 208 can be rotated in conjunction with rotation of the boom. As still another example, the lift surface 204b can be fixed, and the tilting propulsor 208 can be operated to move or rotate only the hub and blade.

In the present disclosure, it is described that the tilting propulsor and the non-tilting propulsor are arranged as illustrated in FIG. 2. However, the present disclosure is not limited to the arrangement of FIG. 2, and these propulsors can be arranged at different locations. Further, FIG. 2 illustrates two tilting propulsors and four non-tilting propulsors, but the present disclosure is not limited to the above numbers, and the numbers can be modified in various numbers. Modified implementations related to the arrangement and number of the tilting propulsors and the non-tilting propulsors can be designed in various forms not mentioned in the present disclosure.

The aircraft 200 can include a landing gear 214 that may or may not be stretched to land on the land and/or the water. The landing gear 214 can be disposed on both a front side and a rear side of the aircraft 200 and include a wheel, a tread, a pontoon, or other components that can help the air mobility device land on the land and/or the water. Further, the aircraft 200 can include a stepper and a side door that can be extracted from the fuselage 202 when the passenger gets on and off.

A module constituting the aircraft according to the present disclosure will be described with reference to FIG. 3. FIG. 3 is a schematic view illustrating modules of the aircraft according to the present disclosure.

The aircraft 200 can include a sensing unit 225, a transceiver 230, a load device 235, and an input/output interface 240. Further, the aircraft 200 can include an actuating unit 245 that includes a propulsor 250, the power source unit 255, and a cooling unit 260. The aircraft 200 can include a storage unit 270 and a controller 275.

The sensing unit 225 can include various types of detectors that detect various states and situations occurring in an external environment and inside a device of the aircraft 200. Further, the sensing unit 225 can have a positioning sensor (or a navigation device) that identifies location information of the aircraft 200. The sensing unit 225 can acquire sensor data used for flight control, state data for detecting a state of the module constituting the aircraft 200, situation data for detecting a situation of the passenger and/or the load, and the like, and provide the acquired data to the controller 275 that can cause a predetermined function and operation.

For example, the sensing unit 225 can include a voltage/current sensor, a temperature sensor, an environmental sensor, and a resistance sensor.

The voltage/current sensor can detect, for example, an electrical state of at least one of an electric battery of the power source unit 255 and the motor and the inverter of the propulsor 250. The temperature sensor can detect, for example, a temperature of at least one of the heterogeneous power source module constituting the power source unit 255 and the motor and the inverter of the propulsor 250.

The environmental sensor can include, for example, a camera, a radar sensor, a lidar sensor, and the like, and can detect the external environment. The resistance sensor can detect, for example, an operation resistance of at least one of the power source module of the power source unit 255 and the motor and the inverter of the propulsor 250. The controller 275 can detect a flight mode, a flight control state, control states of the battery, the motor, and the inverter, a charging state, and a failure/abnormal situation, based on resistance data of the battery, the motor, and the inverter detected from the resistance sensor.

The types and data of the sensing unit 225 are merely exemplary, and the sensing unit 225 can include a detector that detects various states of the propulsor 250. In some implementations, a sensor for detecting various situations that are not listed therein and sensor data can be additionally included.

The transceiver 230 can support mutual communication with other devices to exchange data with the other external devices. In the present disclosure, the other devices can be, for example, the inspection device 100. In some implementations, the other devices can be a management device that controls the aircraft 200 or exchanges data related to movement control of the aircraft 200, an auxiliary device for supporting movement, and other mobility devices. The management device can be implemented as a server, and the inspection device 100 can transmit the diagnostic data in communication with the management device.

The load device 235 can be an auxiliary device that is mounted on the aircraft 200 and consumes power supplied from the power source unit 255 or obtained by converting the power of the power source unit 255 by an instruction required for use of a user or management of a load. The load device 235 can be a type of electrical device that implements other functions except for an operation of the actuating unit 245 in the present disclosure. The load device 235 can be, for example, an avionics equipment system, a display system, an air conditioning system, a lighting system, a seat system, and various devices installed in the aircraft 200.

The aircraft 200 can include an interface that receives a request for movement control and an operation of the load device 235. The interface can be implemented as a hardware device, a software interface, or the like. The hardware interface is a hardware manipulator for a movement operation required for the aircraft 200 by the user, and can be, for example, an aircraft control stick, but the present disclosure is not limited thereto. The software interface can be, for example, a touchable input display, but the present disclosure is not limited thereto. The input/output interface 240 can provide an operation state of the aircraft 200 and a state of the aircraft 200 that are output in response to the request in various sensory forms. In the present disclosure, the diagnostic data by the inspection device 100 can be transmitted to the input/output interface 240 such as a display.

The actuating unit 245 can constitute an actuating unit that transmits power generated from the power source unit 255 to implement a predetermined flight operation, an attitude, and an operation of removing a flight anomaly. In the present disclosure, the actuating unit is referred to as an actuator, and these terms can be described interchangeably. In some implementations, the actuating unit 245 can include a propulsion system actuator and a non-propulsion system actuator. The non-propulsion system actuator can include at least one module that implements the flight operation. The non-propulsion system actuator can include, for example, a mechanical and software component that performs at least one of control of flight attitudes such as a roll, a yaw, and a pitch of the aircraft 200, hovering control related to take-off and landing, flap and elevator control for altitude change and aileron and rudder control for turning operation. Further, the non-propulsion system actuator can have a component that eliminates or prevents anomalies caused during flight. The non-propulsion system actuator can include, for example, a component for preventing icing build up and an icing prevention/removal device.

In the present disclosure, the propulsor 250 can correspond to the propulsion system actuator. As illustrated in FIG. 4, the propulsor 250 can include a propeller having a plurality of blades, a hub, a motor, an inverter, and the like. FIG. 4 is a view illustrating modules constituting the inspection device according to the implementation of the present disclosure and illustrating components of the aircraft, which are inspected by the inspection device. The inverter can, for example, convert direct current (DC) power applied from the power source unit 255 into alternating current (AC) power and supply the converted AC power to the motor. When the aircraft 200 is of a tilting rotor type, at least some of the plurality of propulsors 250 can be tilted. When the aircraft 200 is of a lift-and-cruise type, the plurality of propulsors 250 can have a propulsor for hovering and a propulsor for cruising. When the aircraft 200 is of a multicopter type, the plurality of propulsors 250 can be designed to have propellers arranged parallel to the fuselage 202. The controller 275 can control driving and tilting of each of the plurality of propulsors 250 based on a flight mode (e.g., cruising flight, hovering, take-off and landing, turning, or the like) applied to the above-described propulsion method.

The power source unit 255 can generate and supply power and/or electric power used in the load device 235, the input/output interface 240, and the actuating unit 245. In the present disclosure, the propulsor 250 of the actuating unit 245 can be driven by electric energy, and the power source unit 255 can include a module for supplying power. The power source unit 255 can be formed as a rechargeable electric battery as an example or can have the heterogeneous power source module as another example as illustrated in FIG. 4. When the power source unit 255 has the heterogeneous power source module, the power source unit 255 can include an electric battery and at least one power source capable of self-power generation. The battery can be charged by an external charger during parking of the aircraft 200 or can be charged from a power source capable of self-generating during flight. The battery can supply the power to the actuating unit 245, the load device 235, and the like. A plurality of batteries can be mounted, and the plurality of batteries can be multi-connected to the propulsors 250 for redundancy for resolving abnormal situations of the battery and the propulsor 250. As illustrated in FIG. 4, the power source including the battery can include a DC/DC converter that adjusts power supplied to the actuating unit 245 and the load device 235.

As illustrated in FIG. 4, the power source can include at least one fuel cell and an internal combustion engine-based generator. The fuel cell and the engine-based generator can supply power to the actuating unit 245 and the load device 235 according to the flight mode and a power operating mode or charge the battery during flight. The power operating mode can be a power control scheme between heterogeneous power source modules based on an operation of at least one of the propulsor 250, the non-propulsion system actuator of the actuating unit 245, and the load device 235, which may be required in the flight mode.

As an example, the fuel cell and engine-based generator can supply power to the propulsor 250 in parallel with the battery in a high-output power operating mode and supply power to the propulsor 250 without support of power from the battery in a low-output power operating mode. As another example, the battery can be basically used in all power operating modes, and the fuel cell and the engine-based generator can auxiliarily apply power to the propulsor 250 and the load device 235 in a specific power operating mode.

As illustrated in FIG. 4, the power source including the fuel cell can include a DC/DC converter and a cell fuel storage that supplies hydrogen to the fuel cell. The DC/DC converter can adjust power supplied to the actuating unit 245, the load device 235, and the battery. The power source including the engine-based generator can include an engine, a generator, an AC/DC converter, and an engine fuel storage that supplies fuel to the engine. The AC/DC converter can convert a form of the power supplied to the actuating unit 245, the load device 235, and the battery or can adjust the power.

As illustrated in FIG. 4, the cooling unit 260 can include a cooler that performs cooling by exchanging heat with the heterogeneous power source module and the propulsor 250. The powertrain architecture has a sufficient cooling system for each of subsystems, that is, the power source module and the propulsor, and thus performance can be flexibly inspected independently of thermal elements even in various hybrid combinations.

Meanwhile, the storage unit 270 can store an application and various types of data for controlling the aircraft 200 and load the application or read and record the data according to a request of the controller 275. The application and the data can include sensor data related to flight control, state data of an aircraft related to flight control, data received from other devices, and data related to energy control between the power source unit 255 and the propulsor 250. In some implementations, the application and the data can include data related to control of modules responsible for functions other than the above-described control, software related to an operation of a computing system of the mobility, information and application for autonomy movement, route information, various types of information and a control program for convenience of boarding, and the like.

In connection with the present disclosure, the controller 275 can process movement control, route control, energy control, control of the load device 235, autonomous movement control, convenience function control, and the like using the application, the instruction, and the data stored in the storage unit 270. As illustrated in FIG. 4, the controller 275 can have a power integrated controller that collectively controls a power controller and a low-level power controller for each power source to control at least one of output power, power generation, charging, and operation of the heterogeneous power source modules according to the power operating mode. The controller 275 can have a thrust integrated controller that collectively controls a thrust controller and a low-level thrust controller for each propulsor 250 to control at least one of an output power and a behavior of the propulsor 250 according to the flight mode. The powertrain architecture has a control system for each of subsystems, that is, the power source module and the propulsor 250, and thus logics of the low-level controllers and the integrated controllers can be simplified, and at the same time, the performance can be inspected in a flexible hybrid combination manner.

When the aircraft 200 is inspected while being connected to the inspection device 100, the controller 275 can cut off the electrical connections between components to be inspected, such as the power source unit 255, the load device 235, and the actuating unit 245 and can electrically connect the components to the inspection device 100. Accordingly, the components to be inspected are electrically connected inside the inspection device 100 by switching control of the inspection device 100, which will be described below, so that the inspection device 100 can execute an operation according to the inspection mode on the corresponding component and also deactivate a component not related to the inspection mode.

In some implementations, the controller 275 can have a module that processes various functions, and as an example, can be implemented as a single processing module including the controllers. As another example, the process according to the above description can process a plurality of processing modules in a distributed manner, and in the present disclosure, the controller 275 can be collectively referred to as the plurality of processing modules.

Hereinafter, the inspection device according to the implementation of the present disclosure will be described with reference to FIG. 4.

The inspection device 100 can include an input/output unit 110, a switching assembly 120, a power transceiver 130, a measurement unit 140, a memory 150, and a processor 160.

The input/output unit 110 can receive the inspection mode requested by the user and output the diagnostic data for the components, which can be performed by the inspection device 100, in relation to the inspection mode. An input for the inspection mode can be performed through the input/output unit 110 of the inspection device 100 as described above or can be performed through the input/output interface 240 of the aircraft 200 as another example. In the case of the input by the aircraft 200, the inspection device 100 can receive the inspection mode through communication between a transceiver (not illustrated) in the inspection device 100 and the aircraft 200 or can receive the inspection mode through a lane of the inspection device 100, which is connected to the component of the aircraft 200. The inspection mode received from the aircraft 200 can be presented to the input/output unit 110. The input/output unit 110 can be formed as a hardware or software interface. The software interface can be a touchable display.

The switching assembly 120 can include a switch array 124 that is operated to allow or block power flow to at least one of the components having the heterogeneous power source module and/or the propulsor 250. The switch array 124 can have switches that can be arranged along at least one of transmission lanes 121 to 123. The switches can correspond to the components, for example, a power source of the power source module, the propulsor, and the power transceiver 130. In FIG. 4, for convenience of illustration, the transmission lane is illustrated as a single line, but the transmission lane can include a plurality of sub-lanes responsible for power transmission between the components.

When a plurality of transmission lanes 121 to 123 are provided, as an example, the plurality of transmission lanes 121 to 123 can function to divide and supply power. When output power from the battery, the fuel cell, and the engine-based generator is high, the power is not properly transmitted using only the upper transmission lane 121, and thus the power can be transmitted using at least one of the central and lower transmission lanes 122 and 123 as well as the upper transmission lane 121. As another example, one of the plurality of transmission lanes 121 to 123, for example, the upper transmission lane 121, can function as a main transmission lane, and at least another 122 or 123 of the plurality of transmission lanes 121 to 123 can function as a redundancy transmission lane. The redundancy transmission lane can be used as an auxiliary in preparation for an abnormal situation in the main transmission lane or can be used to charge the battery and supply redundancy power to the power source and the propulsor in an abnormal situation.

When the plurality of transmission lanes 121 to 123 are arranged, the switch array 124 can be disposed to have the same arrangement for each of the plurality of transmission lanes 121 to 123. In some implementations, the switch array 124 can be formed as a switching combination in the form of a matrix to have switches corresponding to the same components for each of the plurality of transmission lanes 121 to 123. For example, a switch corresponding to the fuel cell can be arranged equally in each of the transmission lanes 121 to 123, and switches of the engine-based generator, the battery, the propulsor 250, and the power transceiver 130 can be also arranged equally in each of the transmission lanes 121 to 123 as described above. The switches on the plurality of transmission lanes 121 to 123 can be variously turned on/off according to the inspection mode. For example, the switch array 124 on the one side and the other side transmission lanes can be controlled such that, when the inspection mode is an on-board charging mode, power flow to a component (hereinafter, referred to as a third component) including the power source that supplies power to the propulsor 250 and the propulsor 250 is allowed in the one transmission lane (e.g., the upper transmission lane 121), and In some implementations, power flow to a component (hereinafter, referred to as a fourth component) including the battery and the power source that charges the battery is allowed in at least one of the one transmission lane or the other transmission lane (e.g., the central transmission lane 122 and so on). Here, the on-board charging mode can be a manner of charging the battery during flight by at least one of the fuel cell and the engine-based generator.

Further, the switching assembly 120 can include a power lane 125 connected to each of power sources of the heterogeneous power source modules and load lanes 126 and 127 connected to the component that consumes power, in the inspection of the component. The power lane 125 can be referred to as a power lane set in terms of being connected to each of the power sources. The load lanes 126 and 127 can include a propulsor lane 126 connected to each propulsor 250 and an additional load lane 127 connected to the power transceiver 130. The load lanes 126 and 127, the propulsor lane 126, and the additional load lane 127 can also be referred to as a load lane set, a propulsor lane set, and an additional load lane set in terms of being connected to the components acting as a load. Here, the power lane 125 and the propulsor lane 126 can constitute a connection lane.

The power transceiver 130 can provide power to the propulsor 250 or function as a load of the aircraft 200, according to the inspection mode. In FIG. 4, the power transceiver 130 can correspond to an electric power source/sink loader, and in the present disclosure, these terms can be interchangeably used. The load can include at least one of the avionics equipment, the non-propulsion system actuator, and the icing prevention/removal device. Functioning as a load can mean that the above-described load is not mounted on the inspection device 100 in the same manner as the aircraft 200 but has a circuit that consumes power of the corresponding load, which is required in an actual operation of the aircraft 200. Further, the switching assembly 120 can further include the switch array 124 that is operated to allow or block power flow to the power transceiver 130 inside the switching assembly 120. When the inspection mode is a simultaneous power mode, the switch array 124 can be operated to allow power flow to the components including the power source of the power source module, the propulsor 250, and the power transceiver 130. Here, the simultaneous power mode can be a manner of supplying power to the propulsor 250 and the load by at least one of the heterogeneous power source modules. Accordingly, without inspecting the power source module using an actual load of the aircraft 200, inspection for the simultaneous power mode can be easily and simply performed by the power transceiver 130. Meanwhile, when the inspection mode is a manner of inspecting the performance of the propulsor 250 alone while excluding power of the power source module, the power transceiver 130 can supply power to the propulsor 250 to be inspected.

The measurement unit 140 can output sensing data obtained by detecting output power, input power, and a behavior of the corresponding component according to the inspection mode. The measurement unit 140 can include the same sensor as a sensor mounted to measure a state of the corresponding component in the sensing unit 225 of the aircraft 200. For example, the measurement unit 140 can include the voltage/current sensor, the temperature sensor, the resistance sensor, the detector that detects a state of the propulsor 250, and the like. The measurement unit 140 can transmit sensing data to the processor 160 or the aircraft 200.

Further, as described above, the inspection device 100 can include the memory 150 and the processor 160.

The memory 150 can store an application and various types of data for controlling the inspection device 100 and load the application or read and record the data according to a request of the processor 160. The application can adjust the switch array 124 according to the inspection mode to control the power flow to the component of the aircraft 200 within the switching assembly 120 and to output the diagnostic data of the component by an inspection according to the inspection mode. The data can include data related to operation control of the switch array 124 according to the inspection mode, specifications of the power sources of the power source module, specifications of the propulsor 250, and load power of the aircraft 200. The above-described information can be stored in advance or can be obtained through the aircraft 200 connected to the inspection device 100. In some implementations, the application and the data can include data, a control program, or the like, which is related to control of a module in charge of functions In some implementations to the above-described processing.

In connection with the present disclosure, the processor 160 can execute a process of controlling the switch array 124 to allow or block the power flow to the component within the switching assembly 120 based on the inspection mode related to at least one of the heterogeneous power source modules and propulsors 250 by the switching assembly 120 using an application, an instruction, and data stored in the memory 150. This process can be implemented by the switching controller 170. Further, the processor 160 can perform a process of outputting the diagnostic data for the component connected to the switch array 124 by performing an inspection required in the inspection mode. For example, the processor 160 can be implemented as a single processing module. As another example, the process according to the above description can processes a plurality of processing modules in a distributed manner, and in the present disclosure, the processor 160 can be collectively referred to as the plurality of processing modules.

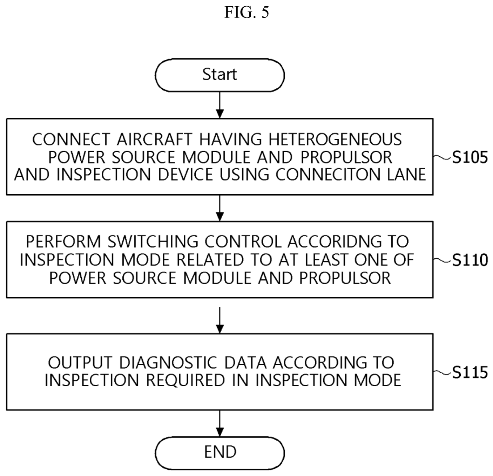

Hereinafter, an inspection method according to another implementation of the present disclosure will be described with reference to FIGS. 1 to 15. FIG. 5 is a flowchart illustrating an inspection method for checking the performance of an aircraft powertrain according to another implementation of the present disclosure. The process of FIG. 5 can be performed by the processor 160 of the inspection device 100, and hereinafter, for convenience of description, the processor 160 can be abbreviated as the inspection device 100 or can be used interchangeably with the inspection device 100.

Referring to FIG. 5, in order to inspect the component of the aircraft 200, the aircraft 200 having the heterogeneous power source module and the propulsor and the inspection device 100 can be connected using the connection lane (S105).

The aircraft 200 can be inspected before takeoff or during maintenance, and the power lane 125 and the propulsor lane 126 are connected to the power source module and the propulsor 250 of the parked aircraft 200, so that the inspection device 100 can be connected to the aircraft 200.

Next, the processor 160 can perform switching control by the switching assembly 120 to allow or block the power flow to the component within the switching assembly 120 based on the inspection mode related to at least one of the power source module and the propulsor 250 (S110). Here, the switching control can be on/off control of an individual switch belonging to the switch array 124.

The user can request the inspection mode through the input/output unit 110 of the inspection device 100 or the input/output interface 240 of the aircraft 200. In this case, the controller 275 of the aircraft 200 can cut off the electrical connections between the components to be inspected, for example, the power source unit 255, the load device 235, and the actuating unit 245, and can electrically connect the components and the inspection device 100.

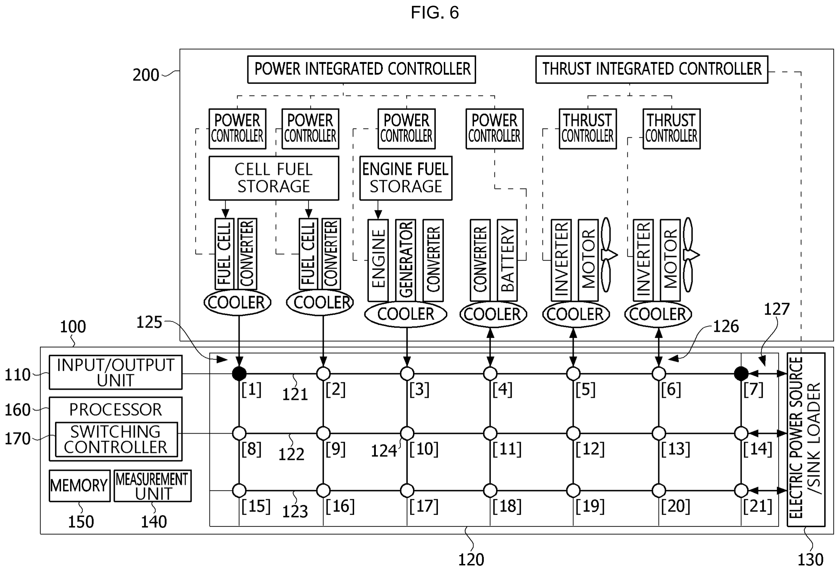

The switching control according to various inspection modes will be described through examples of FIGS. 6 to 15. FIGS. 6 to 14 are views illustrating components of an aircraft, which are diagnosed according to various inspection modes, and switching operations of the inspection device according to an inspection mode.

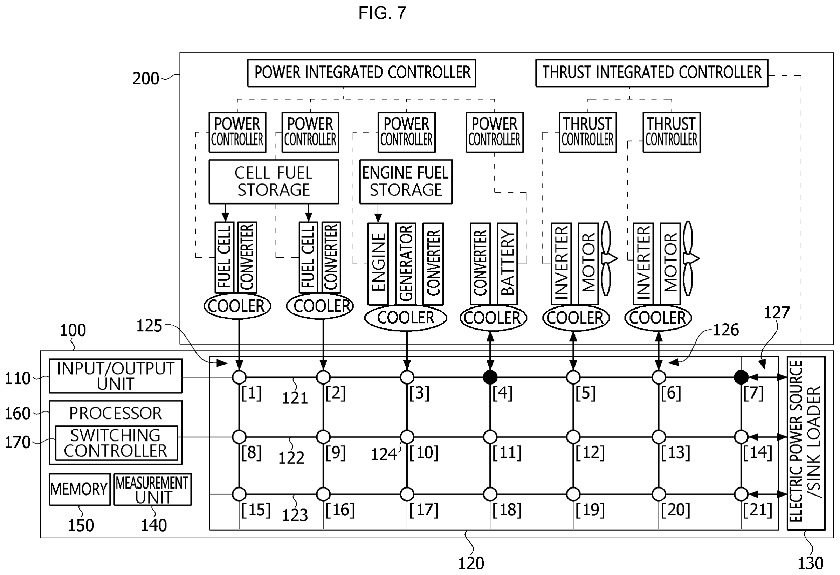

FIGS. 6 and 7 illustrate an operation of the switch array 124 in an inspection mode in which the performance of the power source module is inspected in a single power source.

FIG. 6 can correspond to a switching operation for checking the performance of one power source module among a plurality of fuel cells. Referring to FIG. 6, the switching controller 170 of the processor 160 can turn on switch 1 of the upper transmission lane 121 connected to the fuel cell and turn on switch 7 of the upper transmission lane 121 connected to the electric power source/sink loader 130 that receives power from the fuel cell. The switching controller 170 can turn off the other switches. Accordingly, output power of the fuel cell can be applied to the electric power source/sink loader 130 without being transmitted to other components through the switching assembly 120. The performance of the power source module related to the fuel cell can be performance related to at least one of output power, power generation, and operation control of the fuel cell. This performance can include not only the amount of output and the amount of power generation through the measurement unit 140 and/or the sensing unit 225 but also control operating state and robustness for output power, power generation in the power controller and an integrated power controller. In some implementations, as illustrated in FIG. 6, when a plurality of fuel cells are provided, switch 2 is turned on to inspect the performance of two fuel cells.

FIG. 7 can correspond to a switching operation for checking the performance of the power source module of the battery. Referring to FIG. 7, the switching controller 170 of the processor 160 can turn on switch 4 of the upper transmission lane 121 connected to the battery and turn on switch 7 of the upper transmission lane 121 connected to the electric power source/sink loader 130 that receives power from the battery. The switching controller 170 can turn off the other switches. Accordingly, output power of the battery can be applied to the electric power source/sink loader 130 without being transmitted to other components through the switching assembly 120. As another example, in the case of an inspection mode in which the charging performance of the battery is inspected according to a state of charge (SOC), the electric power source/sink loader 130 can function as a power source that supplies power to the battery. Performance related to the battery can be performance related to at least one of output power, power generation, charging, and operation control of the battery. This performance can include the amount of output power and the amount of power generation through the measurement unit 140 and/or the sensing unit 225 as well as a control operating state and robustness for output power, power generation, and charging in the power controller and integrated power controller of the battery.

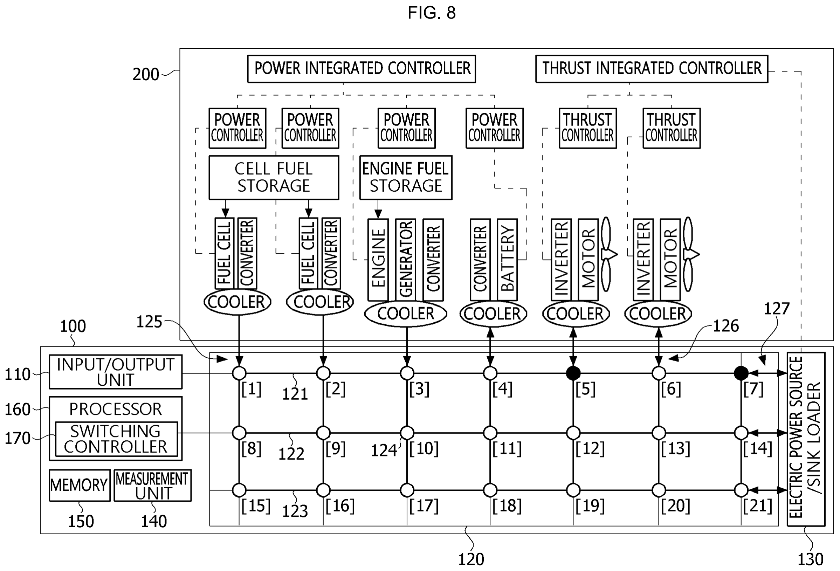

FIG. 8 illustrates an operation of the switch array 124 in an inspection mode in which the performance of the propulsor is inspected in the motor.

The switching controller 170 can turn on switch 5 of the upper transmission lane 121 connected to the propulsor 250 and turn on switch 7 of the upper transmission lane 121 connected to the electric power source/sink loader 130 that supplies power. The switching controller 170 can turn off the other switches. Accordingly, the power of the electric power source/sink loader 130 can be applied to the motor without being transmitted to other components through the switching assembly 120. Performance related to the propulsor can be performance related to output power of the propulsor, a thrust due to the propulsor, and control of the propulsor according to the flight mode of the aircraft. This performance can include the amount of output power of the motor, the amount of output power of the inverter, and the thrust through the measurement unit 140 and/or the sensing unit 225 as well as control operating states and robustness for the propulsor, output power control, and thrust adjustment in the thrust power controller and the integrated thrust controller of the propulsor. In some implementations, as illustrated in FIG. 8, when a plurality of propulsors are provided and the required thrust is high, switch 6 is turned on to inspect the performance of the two propulsors.

Meanwhile, the inspection mode can have a method of mixedly checking the performance according to various connection combinations between at least one of the power source module and the propulsor 250, that is, the performance of the power source module and the performance of the propulsor. For example, a state of each component due to flow of power between the single propulsor and the plurality of power sources, a state of each component due to flow of power between the plurality of propulsors and the plurality of power sources, and the like can be an inspection target. Control of the switch array 124 for connection combinations of the components according to various inspection modes can be processed as represented in Table 1. A switch number in Table 1 can correspond to switches 1 to 21 belonging to the switch array 124 of FIGS. 6 to 8.

Table 1 lists connection combinations implemented by controlling opening or closing of the power lane 125, the transmission lanes 121 to 123, and the load lanes 126 and 127 according to on/off driving of switches 1 to 6. The other switches 8 to 21 are turned off. The performance of various architectures can be simply inspected only by an operation of the switch.

When the flow of power according to the above connection combination is described as an example by No.21 of Table 1, power of each of the two fuel cells, the generator, and the battery can flow to at least one of the two propulsors 250 through the power lane 125, the transmission lanes 121 to 123, and the propulsor lane 126 according to the flight mode defined in the inspection mode. Further, the power of each of the two fuel cells and the generator can flow to the battery through the power lane 125 and the transmission lanes 121 to 123 according to the mode defined in the inspection mode, that is, the power operating mode and the flight mode. The flow of power has been described as an example of No. 21, but in the other case of Table 1, the power between the components connected to the turned-on switches can flow based on at least one of the power operating mode and the flight mode defined in the inspection mode.

**[Table 1]**

| No. | Motor number | Powertrain architecture | Switch number | | | | | |
|---|---|---|---|---|---|---|---|---|
| | | | 1 | 2 | 3 | 4 | 5 | 6 |
| 1 | Single | All battery electric | - | - | - | On | On | - |
| 2 | Single | Single fuel cell electric | On | - | - | - | On | - |
| 3 | Single | Dual fuel cell electric | On | On | - | - | On | - |
| 4 | Single | All engine electric | - | - | On | - | On | - |
| 5 | Single | Engine-battery series | - | - | On | On | On | - |
| 6 | Single | Dual fuel cell-battery series | On | On | - | On | On | - |
| 7 | Single | Single fuel cell-battery series | On | - | - | On | On | - |
| 8 | Single | Dual fuel cell-engine series | On | On | On | - | On | - |
| 9 | Single | Single fuel cell-engine series | On | - | On | - | On | - |
| 10 | Single | Single fuel cell-engine-battery series | On | - | On | On | On | - |
| 11 | Single | Dual fuel cell-engine-battery series | On | On | On | On | On | - |
| 12 | Dual | All battery electric | - | - | - | On | On | On |
| 13 | Dual | Single fuel cell electric | On | - | - | - | On | On |
| 14 | Dual | Dual fuel cell electric | On | On | - | - | On | On |
| 15 | Dual | All engine electric | - | - | On | - | On | On |
| 16 | Dual | Engine-battery series | - | - | On | On | On | On |
| 17 | Dual | Dual fuel cell-battery series | On | On | - | On | On | On |
| 18 | Dual | Single fuel cell-battery series | On | - | - | On | On | On |
| 19 | Dual | Dual fuel cell-engine series | On | On | On | - | On | On |
| 20 | Dual | Single fuel cell-engine series | On | - | On | - | On | On |
| 21 | Dual | Single fuel cell-engine-battery series | On | - | On | On | On | On |
| 22 | Dual | Dual fuel cell-engine-battery series | On | On | On | On | On | On |

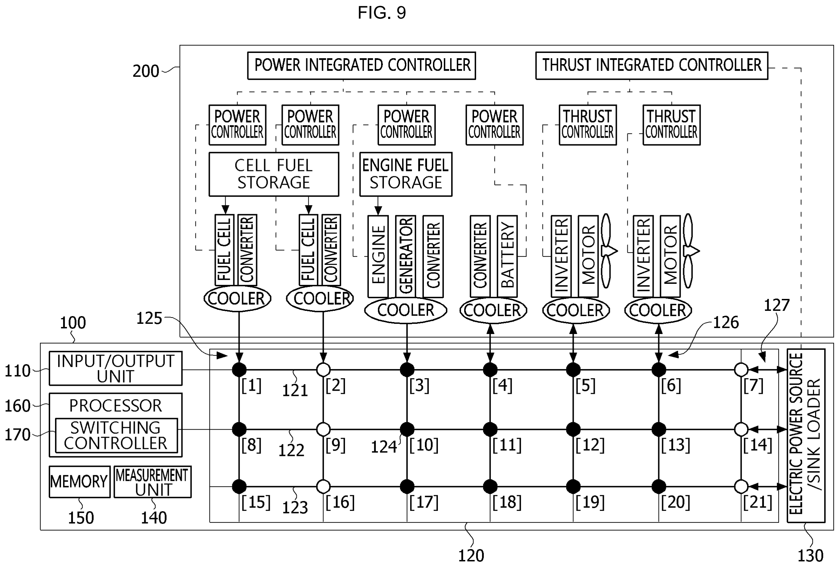

FIG. 9 illustrates an operation of the switch array 124 in a failure mode, on which a scenario related to an abnormal situation of the component is reflected, as an inspection mode.

When the inspection mode is a failure mode due to a defect of at least one of the heterogeneous power source module and the propulsor, the switch array 124 can be operated to block power flow to a first component designated as failure among the power source of the power source module and the propulsor and to allow power flow to a second component designated as normal among the power source of the power source module and the propulsor.

FIG. 9 illustrates switching control corresponding to a case in which a specific fuel cell is designated as failure and another fuel cell, the engine-based generator, and the plurality of propulsors are designated as normal. The switching controller 170 can turn off switches 2, 9, and 16 on the transmission lanes 121 to 123 connected to the fuel cell designated as failure and turn on switches 1, 3 to 6, 8, 10 to 13, 15, and 17 to 20 on the transmission lanes 121 to 123 connected to other components. In the failure mode, as an example, the switching controller 170 can control the switch array 124 to turn off a switch related to the component designated as failure from start of the inspection. As another example, at the start of the inspection, the switching controller 170 can control the switch array 124 to turn on both a switch related to the component designated as failure by the user and a switch related to the normal component, and then turn off the switch corresponding to the failure component after a predetermined time. The flow of power including FIG. 9 can be substantially the same as that described in Table 1.

Redundancy performance in the failure mode can be performance related to redundancy of the propulsor in an abnormal situation, power distribution of the normal power source module, and power block of the failure power source module. This performance can include not only the amount of output power of the motor, the amount of output power, the amount of charge, and the amount of power generation of the power source, and the turn-off of the failure power source through the measurement unit 140 and/or the sensing unit 225 but also the control operating states and the robustness for redundancy in all the controllers.

Table 2 lists combinations of failure scenarios of single/dual components, which can be implemented in dual fuel cells, the engine-based generator, the battery, and dual motor-based architectures by controlling the switches on transmission lanes 121 to 123. Switch numbers in Table 2 can correspond to switches 1 to 21 belonging to the switch array 124 of FIG. 9. Accordingly, various combinations of failure scenarios of the components can be provided, and accurate inspection according to various failure scenarios can be implemented.

**[Table 2]**

| Switch number | Normal state | Component with failure | | | | | | |
|---|---|---|---|---|---|---|---|---|
| | | Single fuel cell | Single engine | Single battery | Single motor | Single bus | Dual fuel cell | Dual bus |
| 1 | On | On | On | On | On | On | - | On |
| 2 | On | - | On | On | On | On | - | On |
| 3 | On | On | - | On | On | On | On | On |
| 4 | On | On | On | - | On | On | On | On |
| 5 | On | On | On | On | On | On | On | On |
| 6 | On | On | On | On | - | On | On | On |
| 7 | - | - | - | - | - | - | - | - |
| 8 | On | On | On | On | On | On | - | - |
| 9 | On | - | On | On | On | On | - | - |
| 10 | On | On | - | On | On | On | On | - |
| 11 | On | On | On | - | On | On | On | - |
| 12 | On | On | On | On | On | On | On | - |
| 13 | On | On | On | On | - | On | On | - |
| 14 | - | - | - | - | - | - | - | - |
| 15 | On | On | On | On | On | - | - | - |
| 16 | On | - | On | On | On | - | - | - |
| 17 | On | On | - | On | On | - | On | - |
| 18 | On | On | On | - | On | - | On | - |
| 19 | On | On | On | On | On | - | On | - |
| 20 | On | On | On | On | - | - | On | - |
| 21 | - | - | - | - | - | - | - | - |

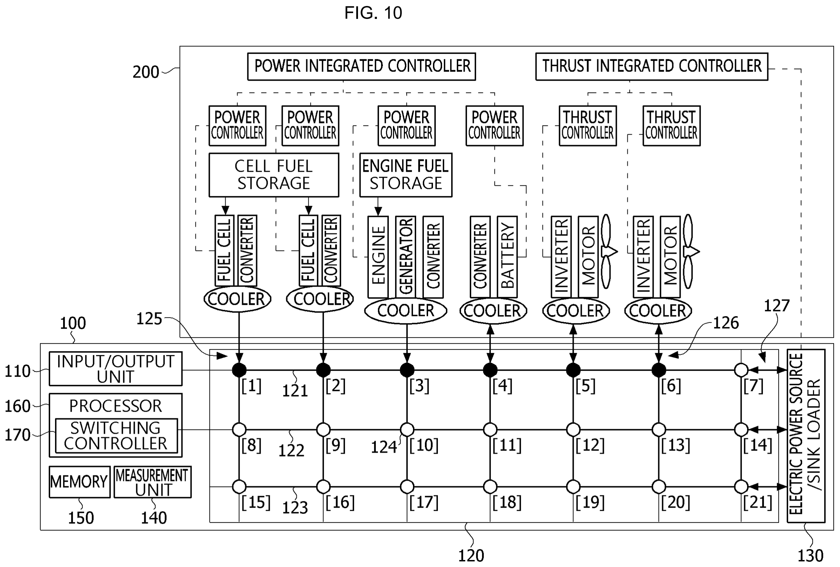

FIGS. 10 to 12 illustrate an operation of the switch array 124 in an on-board charging mode in which the battery is charged as the inspection mode. The on-board charging mode can be a mode related to a scenario in which the battery is charged by at least one of the fuel cell and the generator while supplying power to the propulsor on the assumption of a flight situation. The operation of the switch array 124, which simulates the scenario, can be performed using a switch on a single transmission lane or using a switch on a plurality of transmission lanes.

FIG. 10 shows a switching operation that can be for checking the performance according to the on-board charging mode using the switch on the single transmission lane. In the case of an architecture including the two fuel cells, the engine-based generator, the battery, and the propulsor 250, the switching controller 170 can control the switch array 124 to turn on all switches in the upper transmission lane 121 related to the listed components.

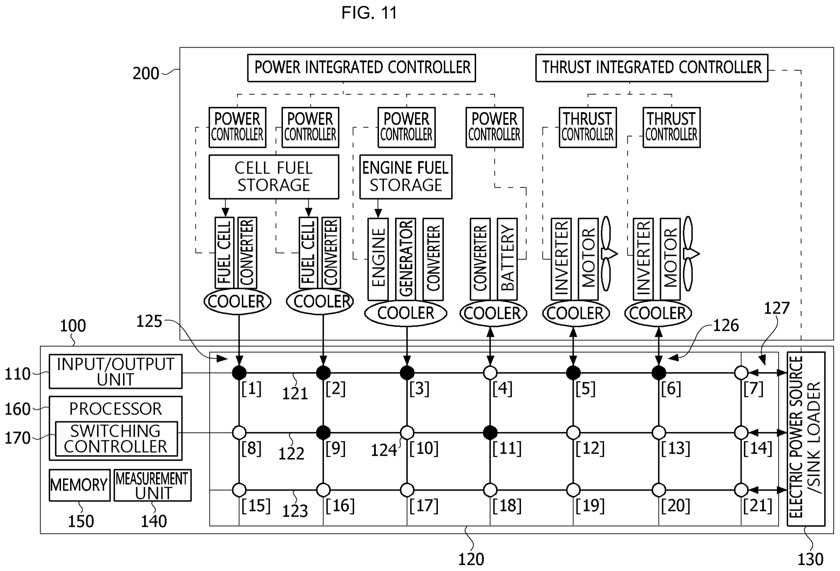

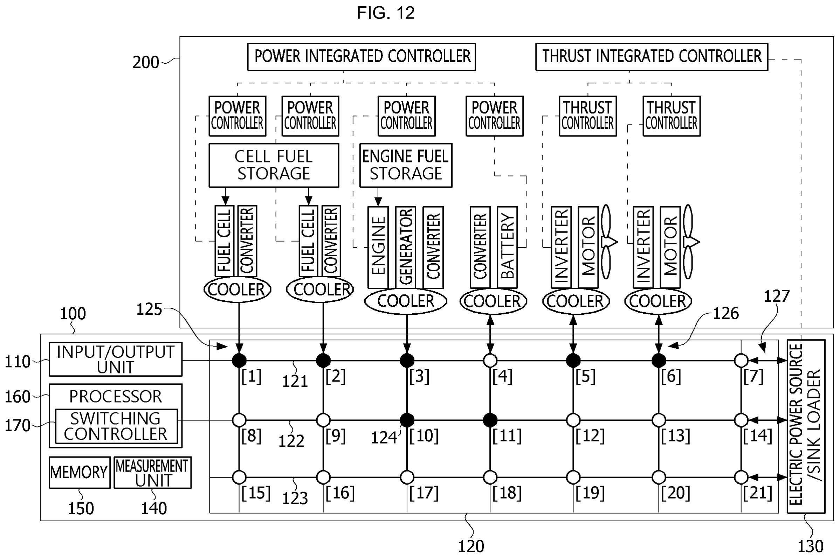

FIGS. 11 and 12 can be a switching operation for checking the performance according to the on-board charging mode using the switches on the plurality of transmission lanes. As illustrated in FIG. 10, switching control according to the on-board charging mode can be implemented such that power of all of the power source modules flows together to the upper transmission lane 121.

Unlike this, when battery charging speed needs to be controlled while an impact on the entire system is minimized, as illustrated in FIGS. 11 and 12, in the switching control, a power source for charging the battery and capable of self-power generation and a transmission line of the battery can be mapped to separate transmission lanes. Here, the power source can be a fuel cell or an engine-based generator.

FIG. 11 illustrates switching control related to a situation in which the battery is on-board charged by the fuel cell. Here, the switching controller 170 can control the switch array 124 on the one side and the other side transmission lanes 121 and 122 to allow power flow to the third component including the power source (e.g., the fuel cell and the engine-based generator) that supplies power to the propulsor 250 and the propulsor 250 on the one side transmission lane (e.g., the upper transmission lane 121) and also to allow power flow to the fourth component including the battery and the power source (e.g., the fuel cell) that charges the battery in the other transmission lane (e.g., the central transmission lane 122). FIG. 11 illustrates that a switch marked in black is turned on.

FIG. 12 illustrates switching control related to a situation in which the battery is on-board charged by the engine-based generator. The switching controller 170 can control the switch array 124 on the upper and central transmission lanes 121 and 122 to allow power flow to the third component including the fuel cell, the engine-based generator, and the propulsor 250 in the upper transmission lane 121 and also to allow power flow to the fourth component including the battery and the generator that charges the battery. FIG. 12 illustrates that a switch marked in black is turned on.

Performance related to the on-board charging mode, that is, on-board charging performance, can be performance related to charging control and operation control between the power sources constituting the power source module according to the power operating mode of the aircraft. This performance can include the amount of output power, the amount of power generation, and the amount of charging of the power source through the measurement unit 140 and/or the sensing unit 225 as well as a control operating state and robustness for output power, power generation, and charging in the power controller and integrated power controller of the power source.

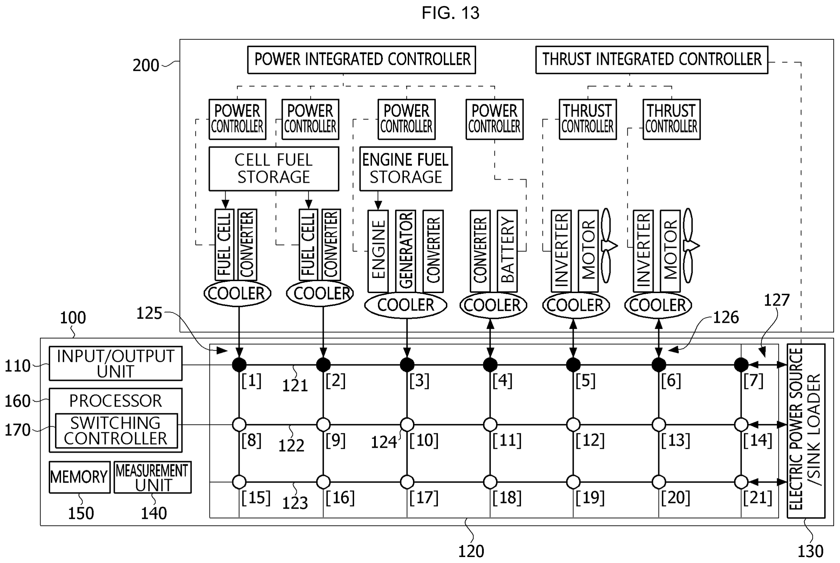

FIG. 13 illustrates an operation of the switch array 124 in the inspection mode related to the simultaneous power mode. The simultaneous power mode can be a mode in which power is supplied to loads of the propulsor 250 and the aircraft 200 by at least one of the heterogeneous power source modules. The simultaneous power mode can mean a mode in which propulsion and power-off take are implemented.

The switching controller 170 can control the switch array 124 to allow the power flow to the components including the heterogeneous power source module, the propulsor 250, and the power transceiver 130. The power transceiver 130 can be configured to receive power required for a specified load in the inspection mode. The load can include, for example, at least one of the avionics equipment mounted on the input/output interface 240, the non-propulsion system actuator, and the icing prevention/removal device belonging to the load device 235. FIG. 13 illustrates that, in the case of an architecture having the dual fuel cell, the generator, the battery, and the dual propulsor 250, the electric power source/sink loader 130 that virtually functions as the specified load in the inspection mode receives power from at least one of the power sources of the power source module by turning on the switch on the upper transmission lane 121. FIG. 13 illustrates that a switch marked in black is turned on. Further, FIG. 13 illustrates that the power of the power sources can flow to the dual propulsor 250 according to the flight mode and the power operating mode defined in the inspection mode. Accordingly, without inspecting the power source module using the actual load of the aircraft 200, the inspection for the simultaneous power mode can be easily and simply performed by the power transceiver 130.

Performance related to the simultaneous power mode can be performance related to at least one of output power and power generation of the power source constituting the power source module and operation control of a load. This performance can include the amount of output power of the power source, the amount of power consumption of the load, an operation control state of the power source, the amount of output power of the motor through the measurement unit 140 and/or the sensing unit 225 as well as the control operating state and robustness for the simultaneous power mode in all the controllers.

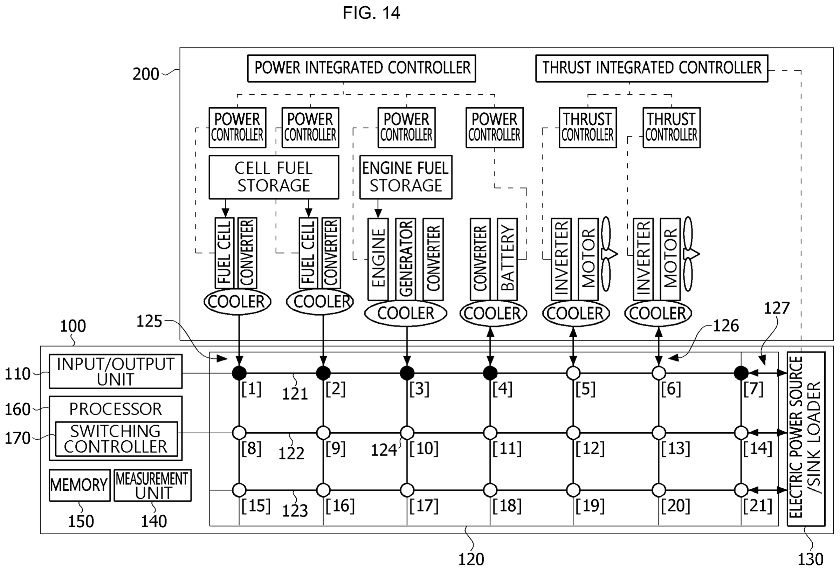

FIG. 14 illustrates an operation of the switch array 124 in the inspection mode related to a source hybrid mode. The source hybrid mode can be a mode in which power is supplied to the load by performing power control based on combination power of the heterogeneous power source module.

The switching controller 170 can control the switch array 124 to allow the power flow to only the component including the power source module and the power transceiver 130 so as to apply power of the heterogeneous power source modules to the power transceiver 130 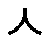 . The power transceiver 130 can be configured to receive power required for the specified load in the inspection mode. The load can be a device of the aircraft 200 described in FIG. 13 or can include other devices of the load device 235. FIG. 14 illustrates that, in the case of an architecture having the dual fuel cell, the generator, the battery, and the dual propulsor 250, the electric power source/sink loader 130 that virtually functions as the specified load in the inspection mode receives power from at least one of the power sources of the power source module by turning on the switch on the upper transmission lane 121. FIG. 13 illustrates that a switch marked in black is turned on. Further, the switch related to the propulsor 250 is turned off, so that power of the power source module does not flow to the propulsor 250. Accordingly, without inspecting the power source module using the actual load of the aircraft 200, the inspection for the source hybrid mode can be easily and simply performed by the power transceiver 130. Meanwhile, performance related to the source hybrid mode is similar to the performance described in FIG. 13.

Referring back to FIG. 5, the processor 160 can output the diagnostic data for the component connected to the switch array 124 by performing an inspection required in the inspection mode (S115).

The inspection mode can be, for example, the modes described with reference to FIGS. 6 to 14. The inspection can cause power and operation in the power source module, the propulsor 250, and the power transceiver 130 according to detailed conditions defined in the inspection mode to generate the diagnostic data of the component.

The diagnostic data can be performance data derived from the inspection according to the inspection mode. The diagnostic data can be, for example, data representing at least one of the redundancy performance due to abnormal situations of the power source module and the propulsor, the performance of the power source module, the on-board charging performance between the power source modules, and the performance of the propulsor. Descriptions of the performances are substantially the same as those of FIGS. 6 to 14, and thus will be omitted. The diagnostic data can be provided to at least one of the input/output unit 110 of the inspection device 100 and the input/output interface 240 of the aircraft 200.

In the above implementation, in the aircraft 200, performance inspection of the powertrain including the fuel cell and the engine-based generator In some implementations to the battery has been mainly described. However, the present implementation can be similarly applied to performance inspection of the powertrain including one of the battery, the fuel cell, and the generator.

In the present implementation, the aircraft has been mainly described, but when a mobility device moving on the ground, on the sea, and under the sea has a power source unit including a single electric battery or a combination of the electric battery/self-generated power source, the above-described implementations can be applied to various types of mobility devices within a range that is not technically violated.

According to the present disclosure, it is possible to provide an inspection device and method for simply and easily checking the performance of an aircraft powertrain on-site without actual flight by providing a flexible powertrain architecture tailored to the operational environment requiring inspection in an electrified powertrain of an aircraft having heterogeneous power sources and an electric propulsor.

Specifically, performance inspections can be conducted efficiently by freely configuring hybrid combinations of power sources such as batteries, fuel cells, and internal combustion engine-based generators.

Additionally, through a switch array on multiple transmission lanes, failure modes related to power sources and propulsion devices can be simulated, enabling inspection of the control operational state of the powertrain corresponding to failure modes and verification of the robustness of the integrated controller managing the power sources and propulsors.

Furthermore, by implementing various power operation environments, such as power control and battery charging for propulsion devices, non-propulsion system actuators of the aircraft, and anti-icing and de-icing functions, in a manner substantially identical to actual conditions, the diagnosis of the powertrain can be performed, making performance inspections more efficient.

Effects obtained in the present disclosure are not limited to the above-mentioned effects, and other effects not mentioned above can be clearly understood by those skilled in the art from the following description.

While the exemplary methods of the present disclosure described above are represented as a series of operations for clarity of description, it is not intended to limit the order in which the steps are performed, and the steps can be performed simultaneously or in different order as necessary. In order to implement the method according to the present disclosure, the described steps can further include other steps, can include remaining steps except for some of the steps, or can include other additional steps except for some of the steps.

The various implementations of the present disclosure are not a list of all possible combinations and are intended to describe representative aspects of the present disclosure, and the matters described in the various implementations can be applied independently or in combination of two or more.

In some implementations, various implementations of the present disclosure can be implemented in hardware, firmware, software, or a combination thereof. In the case of implementing the present disclosure by hardware, the present disclosure can be implemented with application specific integrated circuits (ASICs), Digital signal processors (DSPs), digital signal processing devices (DSPDs), programmable logic devices (PLDs), field programmable gate arrays (FPGAs), general processors, controllers, microcontrollers, microprocessors, etc.

In some implementations, the processor (e.g., processor 160) discussed in the present disclosure may include one or more processors. In some implementations, all of the functions of the processor may be performed by a single processor. In other implementations, the functions of the processor may be distributed among multiple processors (e.g., one processor performs a subset of the functions of the processor 160 while one or more other processors perform the remaining functions of the processor 160.)

The scope of the disclosure includes software or machine-executable commands (e.g., an operating system, an application, firmware, a program, etc.) for enabling operations according to the methods of various implementations to be executed on an apparatus or a computer, a non-transitory computer-readable medium having such software or commands stored thereon and executable on the apparatus or the computer.

## Claims

1. An inspection device for checking performance of a powertrain for a mobility apparatus, the inspection device comprising:
a switching assembly including a switch array configured to allow or block power flow to at least one component among a plurality of components of an aircraft having a heterogeneous power source module and a propulsor driven by the power source module; and
one or more processors configured to:
control the switch array to allow or block the power flow to the at least one component based on an inspection mode related to at least one of the power source module or the propulsor; and
output diagnostic data for the at least one component by performing an inspection according to the inspection mode.

2. The inspection device of claim 1, wherein the heterogeneous power source module includes a rechargeable battery and at least one power source that allows self-power generation, and at least one of the rechargeable battery or the at least one power source is configured to supply power to the propulsor, and
wherein, based on the inspection mode being a failure mode indicating a defect of at least one of the heterogeneous power source module or the propulsor, the one or more processors are configured to control the switch array to:
block power flow to a first component among the plurality of components, wherein the first component is identified as failed; and
allow power flow to a second component among the plurality of components, wherein the second component is identified as normal.

3. The inspection device of claim 1 or 2, wherein the heterogeneous power source module includes a rechargeable battery and at least one power source that allows self-power generation, and the power source is configured to charge the rechargeable battery,
wherein the switch array is disposed along a plurality of transmission lanes and has a same arrangement in each of the plurality of transmission lanes, and
wherein, based on the inspection mode being an on-board charging mode in which the battery is charged, the one or more processors are configured to control the switch array on a first transmission lane and a second transmission lane among the plurality of transmission lanes to:
allow power flow, on the first transmission lane, to a third component including the propulsor and a power source configured to supply power to the propulsor, and
allow power flow, on at least one of the first transmission lane or the second transmission lane, to a fourth component including the rechargeable battery and the power source configured to charge the rechargeable battery.

4. The inspection device of anyone of claims 1-3, comprising a power transceiver configured to provide power to the propulsor or function as a load of the aircraft according to the inspection mode,
wherein the switching assembly includes a switch array operated to allow or block power flow to the power transceiver inside the switching assembly.

5. The inspection device of claim 4, wherein the heterogeneous power source module comprises a plurality of heterogeneous power source modules, wherein, based on the inspection mode being a simultaneous power mode in which power is supplied to the propulsor and the load by at least one heterogeneous power source module of the plurality of heterogeneous power source modules, the one or more processors are configured to control the switch array to allow power flow to components including the at least one heterogeneous power source module, the propulsor, and the power transceiver.

6. The inspection device of claim 5, wherein the power transceiver is configured to receive power required for the load, and the load includes at least one of avionics equipment, a non-propulsion system actuator, and an icing prevention/removal device.

7. The inspection device of claim 4, wherein, based on the inspection mode being a source hybrid mode in which power is supplied to the load by performing power control based on combination power of the at least one heterogeneous power source module, the one or more processors are configured to control the switch array to allow power flow to only a component including the power source module and the power transceiver, thereby applying power of the at least one heterogeneous power source module to the power transceiver.

8. The inspection device of anyone of claims 1-7, wherein the diagnostic data is data representing at least one of redundancy performance due to an abnormal situation of the power source module and the propulsor, performance of the power source module, on-board charging performance between the power source modules, or performance of the propulsor,
wherein the redundancy performance is performance related to redundancy of the propulsor, power distribution of the power source module, and power block of the power source module in the abnormal situation,
wherein the performance of the power source module is performance related to at least one of output power, power generation, charging, and operation control of a power source constituting the power source module,
wherein the on-board charging performance is performance related to charging control and operation control between power sources constituting the power source module according to a power operating mode of the aircraft, and
wherein the performance of the propulsor is performance related to output power of the propulsor and control of the propulsor according to a flight mode of the aircraft.

9. The inspection device of anyone of claims 1-8, wherein the switch array is disposed along a plurality of transmission lanes, and
wherein the plurality of transmission lanes are configured to divide and supply power, or
wherein a first transmission lane among the plurality of transmission lanes is configured to function as a main transmission lane, and at least one second transmission lane among the plurality of transmission lanes is configured to function as a redundancy transmission lane.

10. The inspection device of anyone of claims 1-9, wherein the heterogeneous power source module includes a rechargeable battery and at least one power source that allows self-power generation, the at least one power source includes at least one fuel cell and an internal combustion engine-based generator, and wherein the propulsor comprises a plurality of propulsors.

11. An inspection method of checking performance of a powertrain for a mobility apparatus by an inspection device including a switching assembly having a switch array configured to allow or block power flow to at least one component among a plurality of components of an aircraft having a heterogeneous power source module and a propulsor driven by the power source module, the inspection method comprising:
connecting the aircraft and the inspection device;
controlling, by the switching assembly, the switch array to allow or block the power flow to the at least one component based on an inspection mode related to at least one of the power source module or the propulsor; and
outputting diagnostic data for the at least one component by performing an inspection according to the inspection mode.

12. The inspection method of claim 11, wherein the heterogeneous power source module includes a rechargeable battery and at least one power source that allows self-power generation, and at least one of the rechargeable battery and the power source is configured to supply power to the propulsor, and
wherein, based on the inspection mode being a failure mode indicating a defect of at least one of the heterogeneous power source module and the propulsor, the controlling of the switch array includes operating the switch array to:
block power flow to a first component among the plurality of components, wherein the first component is identified as failed, and
allow power flow to a second component among the plurality of components, wherein the second component is identified as normal.

13. The inspection method of claim 11 or 12, wherein the heterogeneous power source module includes a rechargeable battery and at least one power source that allows self-power generation, and the power source is configured to charge the rechargeable battery,
wherein the switch array is disposed along a plurality of transmission lanes and has a same arrangement in each of the plurality of transmission lanes, and
wherein the controlling of the switch array includes, based on the inspection mode being an on-board charging mode in which the rechargeable battery is charged, operating the switch array on a first transmission lane and a second transmission lane among the plurality of transmission lanes to:
allow power flow, on the first transmission lane, to a third component including the propulsor and the power source configured to supply power to the propulsor, and
allow power flow, on at least one of the first transmission lane or the second transmission lane, to a fourth component including the rechargeable battery and the power source configured to charge the rechargeable battery.

14. The inspection method of anyone of claims 11-13, wherein the inspection device includes a power transceiver configured to provide power to the propulsor or function as a load of the aircraft according to the inspection mode, and the switching assembly includes a switch array operated to allow or block power flow to the power transceiver inside the switching assembly, and
wherein the heterogeneous power source module comprises a plurality of heterogeneous power source modules, wherein the controlling of the switch array includes, based on the inspection mode being a simultaneous power mode in which power is supplied to the propulsor and the load by at least one heterogeneous power source module of the plurality of the heterogeneous power source modules, operating the switch array to allow power flow to components including the at least one heterogeneous power source module, the propulsor, and the power transceiver.

15. A non-transitory computer-readable medium storing one or more instructions for checking performance of a powertrain for a mobility apparatus by an inspection device including a switching assembly having a switch array configured to allow or block power flow to at least one component among a plurality of components of an aircraft having a heterogeneous power source module and a propulsor driven by the power source module, wherein the one or more instructions, when executed by one or more processors, cause the one or more processors to perform operations comprising:
controlling, by the switching assembly, the switch array to allow or block the power flow to the at least one component based on an inspection mode related to at least one of the power source module or the propulsor; and
outputting diagnostic data for the at least one component by performing an inspection according to the inspection mode.
